# EUROPEAN PATENT APPLICATION

(11) **EP 1 067 423 A2**
(43) Date of publication of application: **10.01.2001**
(21) Application number: 00305721.3
(22) Date of filing: 06.07.2000
(51) Int. Cl.: G02F 1/1333

(54) **Liquid crystal display and producing method thereof**

(30) Priority: 06.07.1999 JP 19144299
(71) Applicant: Matsushita Electric Industrial Co., Ltd., Kadoma-shi, Osaka 571-8501 (JP)
(72) Inventor: Ogawa, Kazufumi, Nara-shi, Nara 630-8101 (JP)
(74) Representative: Dempster, Benjamin John Naftel

(57) **Abstract**

A large size liquid crystal display, high in impact resistance and practical safety and excellent in brightness, color display property and display stability, is produced at low cost. In a liquid crystal display in which liquid crystals are filled through a liquid crystal alignment layer in a cell formed by using (i) a TFT array substrate (10) of a first glass substrate (1) forming thereon a number of TFT and (ii) a color filter substrate (20) of a second glass substrate (11) forming thereon a number of color filters and counter electrodes and by combining those substrates in such manner that the TFT and the counter electrodes can be opposed to each other, the glass substrate (1) on the direct vision side having a larger thickness than the opposed glass substrate (11).

## Description

### BACKGROUND OF THE INVENTION

### (1) Field of the Invention

This invention relates to a liquid crystal display and a producing method thereof and, more particularly, to a liquid crystal display having an improved impact-resistance substrate on its display side.

### (2) Description of the Prior Art

In recent years, along with the popularization of personal computers and word processors, the markets for active matrix type liquid crystal displays have been widely expanded and the display screen size of the liquid crystal displays are being increasingly enlarged. Among others, the TFT color liquid crystal displays using thin film transistors (TFT) produced by using amorphous silicon film as an active layer are spectacularly increased in the size of display.

Typically, glass sheets having a thickness of about 1.1mm or less are used for liquid crystal displays, and the production lines (e.g. transferring devices) are designed to fit to the thickness thereof. The glass substrates having this typical thickness are also used to produce large size liquid crystal displays.

However, when the glass substrate having the typical thickness is used to produce a large size liquid crystal display having a 20-inch or more diagonal screen, the display screen becomes insufficient in strength and impact resistance and the problem may occur with safety and durability as the display unit. In addition, the large size substrate suffers from distortion or deflection resulting from its own weight, thus suffering in mask alignment precision in the TFT array process and the color filter process and resultantly suffering from the disadvantage of reduction of an aperture ratio.

Further, that display screen is susceptible to distortion or deflection even after completion of the assembly of the display unit and thus suffers in stability of display. On the other hand, increase in the thickness of the glass substrate will involve changes in the manufacturing facilities such as transferring facilities, thus causing the manufacturing costs to rise and also causing the total weight of the display unit to increase.

### SUMMARY OF THE INVENTION

It is an object of the present invention to eliminate these problems rationally and thereby improve the stability of display and the safety of a large size liquid crystal display, such as a 20-inch or more diagonal display, and the aperture ratio and color display properties thereof, without any drastic rise of manufacturing costs. The object can be achieved by the following construction of the invention.
(1) A liquid crystal display according to the present invention comprises a liquid crystal cell in which a first substrate forming thereon at least thin film transistors and pixel electrodes connected to the thin film transistors and a second substrate forming thereon at least color filter layers and counter electrodes are opposed to each other with a predetermined gap, with electrode surfaces thereof faced inward, and liquid crystals are sealed in the gap, wherein either of both outside surfaces of the liquid crystal cell is on a display side and the substrate on the display side is larger in thickness than the substrate opposed to the substrate on the display side.
   With this construction, since only the substrate on the display side is increased in thickness, the safety and display stability as the display unit can be enhanced without any drastic increase in cost and weight of the device unit.
   In this construction, the feature that the substrate on the display side is the first substrate forming thereon the thin film transistors may further be added. This construction that the thin film transistors (TFT) are formed on the substrate of a larger thickness to thereby produce the TFT array substrate and in turn the TFT array substrate is placed on the display side provides improvements in display stability, brightness and color display property, in addition to safety. This is because the substrate of an increased thickness provides reduced deflection or distortion and logically provides improved dimensional precision of the TFT array in the producing process, and as such can allow the aperture ratio to increase and also can allow the substrate to be resistant to deflection or distortion even after the assembly of the liquid crystal cell and thereby produces enhanced visibility and display stability.
   The color filter may be formed on the substrate having the increased thickness, which in turn will be on the display side. With this variant, mask alignment precision and dimensional precision for a light-shielding pattern to be formed between color filter segments is improved and consequently the color display property is improved. Also, the deflection or distortion of the substrate caused by thermal expansion of a light-shielding film is reduced, even when the light-shielding film is made of metallic chromium or chromium oxide, to the extent corresponding to the increased thickness and strength of the substrate. Hence, improved color display property and display stability is provided.
   In the aforesaid construction (1), the substrate on the display side may comprise a laminated substrate formed by a plurality of transparent substrates being adhesive bonded.
   The construction of a plurality of laminated transparent substrates provides increased strength and impact resistance. Consequently, this construction can provide improved safety and display stability as the display unit. In this construction, for example, a conventional thin substrate may be used as the opposing substrate, while on the other hand, a plurality of conventional substrates laminated may be used as the substrate on the display side. Thus, the display stability and safety can be easily improved without any development of new substrates.
   In the aforesaid construction (1), the substrate on the display side may comprise a composite substrate formed by two transparent substrates being laminated with a polarizer sandwiched therebetween.
   With this construction using the composite substrate sandwiching a polarizer between the two substrates, the outside substrate of the composite substrate operates to protect the polarizer from flaws and the polarizer sandwiched between the two substrates operates to absorb the impact. Consequently, the display stability and impact resistance of the display unit can be significantly improved.
   In the aforesaid construction (1), the substrate on the display side may comprise a composite substrate formed by two transparent substrates being laminated with a transparent resin sheet sandwiched therebetween.
   With the composite substrate sandwiching a resin sheet of different in material from the glass between the glass substrates, the resin sheet having flexibility, when compared with the glass sheet, operates to absorb the impact. This can allow the glass sheet to have resistance to fractures, thus providing significantly improved impact resistance on the display side.
   In the aforesaid construction (1), the substrate on the display side may comprise a borosilicate glass sheet having a thickness in the range of 2 mm or more to 5 mm or less.
   When compared with quartz glass and the like, the borosilicate glass is inexpensive, but is low in strength and is liable to deflect. However, the substrate on the display side having a thickness in the range of 2 mm or more to 5 mm or less can ensure practically substantial strength and impact resistance. The substrate on the display side should have a large thickness in terms of strength and impact resistance, but the practically substantial impact resistance can be obtained with the thickness of not less than 2 mm. On the other hand, with the thickness increased in excess of 5 mm, the demerit of increase in the weight of the display unit will only increase and the safety will no longer be improved. Consequently, the thickness of the substrate on the display side should preferably be in the range of 2 mm or more to 5 mm or less. It is to be noted that this specific thickness of the substrate can be achieved by only a sheet of glass or by a laminated glass sheet of two or more sheets of glasses being adhesive laminated.
   Further, in the aforesaid construction (1), the substrate on the display side may be the first substrate forming thereon the thin film transistors, and the thin film transistors may be formed on the first substrate through a lower layer film having a film thickness in the range of 100 nanometer or more to 10 micron or less.
   As aforementioned, the borosilicate glass is liable to deflect or bend, but when the TFT array is formed on the substrate having a thickness in the range of 2 mm or more to 5 mm or less and forming thereon a lower layer film having a film thickness in the range of 100 nanometer or more to 10 micron or less, the dimensional precision of the TFT array is significantly enhanced. Consequently, the liquid crystal display high in the aperture ratio, brightness and color display properties can be realized. For example, a silicon nitride film or a silica film may be used as the lower layer.
   Further, in this construction, an image display surface on the display side may have a rectangular shape having a diagonal size of 20 inch or more.
   With a large size liquid crystal display having a 20 inch or more diagonal display, the problem is likely to occur with the safety or display stability. When this large size display unit adopts the construction of increasing the thickness of the substrate on the display side or a similar construction, a further satisfactory operation and effect can be yielded.
(2) A liquid crystal display according to another aspect of the invention comprises a liquid crystal cell in which a first substrate forming thereon at least thin film transistors, pixel electrodes connected to the thin film transistors, and color filter layers laminated on the pixel electrodes and a second substrate forming thereon at least counter electrodes are opposed to each other with a predetermined gap, with electrode surfaces thereof faced inward, and liquid crystals are sealed in the gap, wherein either of both outside surfaces of the liquid crystal cell is on a display side and the substrate on the display side is larger in thickness than the substrate opposed to the substrate on the display side.
   With this construction, the TFT and the color filters are both formed on the first substrate, unlike the aforesaid construction (1). With this construction, using the substrate of a large thickness as the first substrate is convenient for enhancing the aperture ratio and the display stability. It is to be noted that the requirements added to this construction are the same as those of the aforesaid construction (1) and the operation and effect are substantially the same as those of the aforesaid construction (1). Accordingly, the description thereon will be omitted hereat.
(3) A liquid crystal display according to still another aspect of the invention is of an in-plane switching type comprising an in-plane switching type liquid crystal cell in which a first substrate forming thereon at least thin film transistors, pixel electrodes connected to the thin film transistors and counter electrodes spaced from the pixel electrodes and a second substrate are opposed to each other with a predetermined gap, with electrode surfaces thereof faced inward, and liquid crystals are sealed in the gap, wherein either of both outside surfaces of the liquid crystal cell is on a display side and the substrate on the display side is larger in thickness than the substrate opposed to the substrate on the display side.
   Even the in-plane switching type makes no difference in that the substrate on the display side is subjected to an external impact. Hence, in the in-plane switching type liquid crystal display thus constructed also, similar operation and effects to those as mentioned in the aforesaid construction (1) can be obtained. In addition, in this construction also, substantially the same requirements as those in the aforesaid construction (1) may be added.
(4) A liquid crystal display according to yet another aspect of the invention comprises a liquid crystal cell in which a first substrate forming thereon at least thin film transistors and pixel electrodes connected to the thin film transistors and a second substrate forming thereon at least color filter layers and counter electrodes are opposed to each other with a predetermined gap, with electrode surfaces thereof faced inward, and liquid crystals are sealed in the gap, wherein either of both outside surfaces of the liquid crystal cell is on a display side and the substrate on the display side is larger in strength per unit volume than the substrate opposed to the substrate on the display side.
   This construction is different from the aforesaid construction (1) only in that the substrate on the display side is higher in strength per unit volume than the opposed substrate. In other words, in this construction, the relation of the strength per unit volume is defined, rather than the thickness of the first and second substrates. The substrate having a high strength is generally expensive, but is resistant to flaws and fractures. Placing the substrate having a larger strength per unit volume on the display side enables the safety and reliability as the display unit to be enhanced without any drastic rise in cost. In this construction as well, a plurality of substrates each having a higher strength per unit volume may be laminated for the intended use or a three-tier structure sandwiching the polarizer or the resin sheet between the substrates may be used. Further, the additional requirements of the aforesaid construction (1) may be added within the range within which no inconsistency will occur.
(5) A liquid crystal display according to a further aspect of the invention is of an in-plane switching type comprising an in-plane switching type liquid crystal cell in which a first substrate forming thereon at least thin film transistors, pixel electrodes connected to the thin film transistors and counter electrodes spaced from the pixel electrodes and a second substrate are opposed to each other with a predetermined gap, with electrode surfaces thereof faced inward, and liquid crystals are sealed in the gap, wherein either of both outside surfaces of the liquid crystal cell is on a display side and the substrate on the display side is larger in strength per unit volume than the substrate opposed to the substrate on the display side.
   This construction is different from the aforesaid construction (3) in that in the in-plane switching type liquid crystal display, the substrate on the display side is larger in strength per unit volume than the opposed substrate. Also, this construction is not substantially different from the above-mentioned construction (4), except for the in-plane switching type liquid crystal display. Accordingly, the contents set forth in the above-mentioned construction (4) apply to this aspect of the present invention.
(6) A liquid crystal display according to the invention can be produced by a producing process comprising:
   a TFT array substrate producing step that after two substrates having different thickness are prepared, at least thin film transistors and pixel electrodes connected to the thin film transistors are formed on the larger thickness one of the two substrates; an opposing substrate forming step that at least transparent counter electrodes are formed on the smaller thickness one of the two substrate; a step that the TFT array substrate and the opposing substrate are opposed to each other with a predetermined gap, with electrode surfaces thereof faced inward; a liquid crystal cell assembling step that liquid crystals are sealed in the gap; a step that a polarizer is placed on each of two outside surfaces of the liquid crystal cell; and a step that a backlight is placed on the opposing substrate of the liquid crystal cell on the side thereof on which the polarizer is placed.
(7) The producing process of a liquid crystal display may comprise a TFT array substrate producing step that after three substrates of first, second and third substrates are prepared, at least thin film transistors and pixel electrodes connected to the thin film transistors are formed on the first substrate; an opposing substrate forming step that at least transparent counter electrodes are formed on the second substrate; a step that the TFT array substrate and the opposing substrate are opposed to each other with a predetermined gap, with electrode surfaces thereof faced inward; a liquid crystal cell assembling step that liquid crystals are sealed in the gap; a laminating step that the third substrate is laminated on an outside surface of the TFT array substrate of the liquid crystal cell so that the entire thickness thereof can be made larger than that of the second substrate; a step that a polarizer is placed on each of two outside surfaces of the liquid crystal cell after the laminating step; and a step that a backlight is placed on the opposing substrate on the side thereof on which the polarizer is placed. This producing process can provide the liquid crystal display with improved productivity.
   In this producing process, the first, second and third substrates may be made of glass and be equal in thickness to each other. In this producing process, since the glass substrates which are equal in the thickness, size and material to each other are used, the liquid crystal display excellent in safety and display stability can effectively be produced without any drastic rise of cost.
   In the producing process of the above (7), different material may be used for the first substrate and the third substrate. For example, the glass sheet is used for the first substrate and the resin sheet may be used for the third substrate (and vice versa). This enables the strength and impact resistance to be adjusted arbitrarily.
(8) A liquid crystal display according to the present invention can be produced, for example, by a producing process comprising a TFT array substrate producing step that after three substrates of first, second and third substrates are prepared, at least thin film transistors and pixel electrodes connected to the thin film transistors are formed on the first substrate; an opposing substrate forming step that at least transparent counter electrodes are formed on the second substrate; a step that the TFT array substrate and the opposing substrate are opposed to each other with a predetermined gap, with electrode surfaces thereof faced inward; a liquid crystal cell assembling step that liquid crystals are sealed in the gap; a laminating step that a polarizer is laminated on an outside surface of the TFT array substrate of the liquid crystal cell and further the third substrate is laminated on the polarizer so that the entire thickness thereof can be made larger than that of the second substrate; a step that a polarizer is placed on an outside surface of the opposing substrate; and a step that a backlight is placed on the opposing substrate on the side thereof on which the polarizer is placed.
   According to this producing process, after the assembly of the cell, the substrate on the display side can be evolved into a composite substrate formed by laminating two substrates with the polarizer sandwiched therebetween. The composite substrate having the sandwiched polarizer is excellent in impact resistance and also the polarizer is protected from flaws or fractures caused by an external force. In other words, according to the producing process, the liquid crystal display of excellent in safety and reliability can be produced in a simply and easy way.
   In this producing process, it is preferable that at least the first and third substrates are made of the glass sheet and the polarizer is made of resin. When the polarizer made of resin is sandwiched between the glass sheets, the polarizer is protected from flaws and also softens the impact applied to the glass. Consequently, the impact resistance (safety) of the display unit is further improved.
(9) A liquid crystal display of the present invention can be produced, for example, by a producing process comprising a TFT array substrate producing step that after four substrates of a first substrate, a second substrate, a third substrate different in material property from the first substrate and a fourth substrate identical in material property to the first substrate are prepared, at least thin film transistors and pixel electrodes connected to the thin film transistors are formed on the first substrate; an opposing substrate forming step that at least transparent counter electrodes are formed on the second substrate; a step that the TFT array substrate and the opposing substrate are opposed to each other with a predetermined gap, with electrode surfaces thereof faced inward; a liquid crystal cell assembling step that liquid crystals are sealed in the gap; a laminating step that the third substrate is laminated on an outside surface of the TFT array substrate of the liquid crystal cell and further the fourth substrate is laminated on the third substrate so that the entire thickness thereof can be made larger than that of the second substrate; a step that a polarizer is placed on an outside surface of the opposing substrate; and a step that a backlight is placed on the opposing substrate on the side thereof on which the polarizer is placed.
   According to this producing process, after the assembly of the cell, the substrate on the display side can be evolved into a composite substrate formed by laminating two substrates with an additional substrate of different material sandwiched therebetween. The composite substrate formed by laminating two substrates with the additional substrate of different material sandwiched therebetween is excellent in impact resistance. Consequently, according to this producing process, the liquid crystal display excellent in safety and reliability can be produced in a simply and easy way and at low cost. Further, in this producing process, when the first substrate is formed of the glass sheet and the third substrate is formed of the resin sheet, the glass sheet and the resin sheet properly interacts to each other. As a result of this, the display substrate of further excellent in impact resistance can be manufactured with good productivity.

In the following, the practical manufacture of the liquid crystal display of the present invention will be described as illustrative.

First of all, two glass substrates, different in thickness from each other, are prepared. Then, the TFT array is formed on the larger thickness one of the two glass substrates. Various types of conventional means may be applied as means to form the TFT array. On the other hand, the color filters are formed on the smaller thickness one of the two glass substrates. Various types of conventional means may be applied as means to form the color filters. Thereafter, known liquid crystal alignment layers are each formed on the TFT array and the color filters. Then, with the liquid crystal alignment layers directed inward, the two glass substrates are aligned with each other, with a predetermined gap kept therebetween, and are adhesive bonded and fixed, to thereby produce an empty cell for the liquid crystal display. Subsequently, liquid crystals are injected into the empty cell in reduced pressure and sealed in the cell to produce the liquid crystal cell. Thereafter, a polarizer is laminated to each of the both outside surfaces of the liquid crystal cell and further a backlight is loaded on the larger thickness substrate side (the color filter substrate side), for completion of the liquid crystal display.

Alternatively, the following process may be adopted. The two glass substrates, different in thickness from each other, are prepared. Then, the color filters are formed on the larger thickness one of the two glass substrates. Various types of conventional means may be applied as means to form the color filters. On the other hand, the TFT array is formed on the smaller thickness one of the two glass substrates. Various types of conventional means may be applied as means to form the TFT array. Thereafter, known liquid crystal alignment layers are each formed on the color filters and the TFT array. Thereafter, the liquid crystal cell is produced in the same manner as the above. Subsequently, the polarizer is laminated to each of the both outside surfaces of the liquid crystal cell and the backlight is loaded on the TFT array substrate side, for completion of the liquid crystal display.

The methods mentioned above are applicable to the producing process of a color-filter-on-array type liquid crystal display in which a plurality of TFT and a plurality of color filters are formed in an accumulating manner on either of the two glass substrates. Further, these methods are also applicable to the producing process of an in-plane switching (IPS) type liquid crystal display in which a plurality of TFT and a plurality of counter electrodes are formed in an accumulating manner on either of the two glass substrates or to the producing process of an in-plane switching (IPS) type liquid crystal display in which a plurality of TFT, a plurality of color filters and the counter electrodes are formed in an accumulating manner on either of the two glass substrates.

### BRIEF DESCRIPTION OF THE DRAWINGS

In the drawings:
FIG. 1 is a conceptual diagram in section of a TFT array substrate of the embodiment 1 of the present invention;
FIG. 2 is a conceptual diagram in section of a color filter of Embodiment 1 of the present invention;

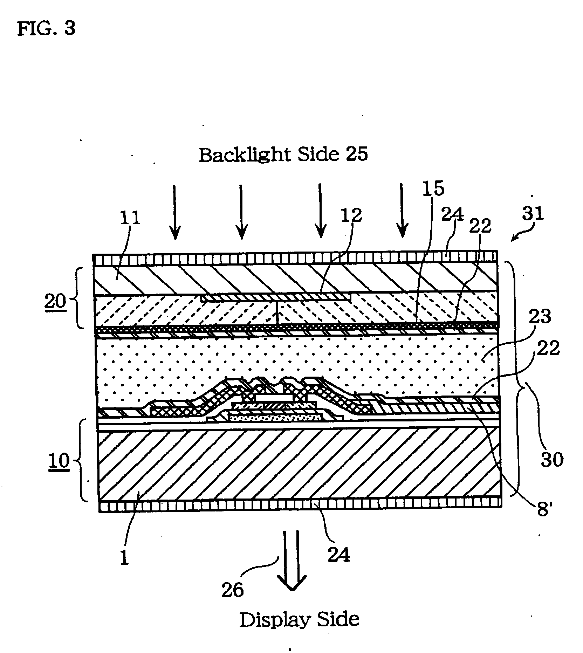

FIG. 3 is a conceptual diagram in section of a liquid crystal display of Embodiment 1 of the present invention;
FIG. 4 is a conceptual diagram in section of a color-filter-on-array type liquid crystal display of another embodiment of the present invention in which the TFT and the color filter are formed on the substrate on the display side; and
FIG. 5 is a conceptual diagram in section of an IPS type liquid crystal display of still another embodiment of the present invention in which the TFT and the pixel electrodes and counter electrodes to be connected thereto are formed on the substrate on the display side.

### DESCRIPTION OF THE PREFERRED EMBODIMENTS EMBODIMENT

The present invention will be described in detail by way of illustrative examples with reference to the accompanying drawings.

### EXAMPLE 1

There were prepared two transparent borosilicate glass sheets (Size: 550 mm × 650 mm/Corning 7059 available from Corning Corp.) each having a size capable to simultaneously produce four substrates used for 20-inch diagonal liquid crystal displays having thickness of 2.5mm and 0.7mm.

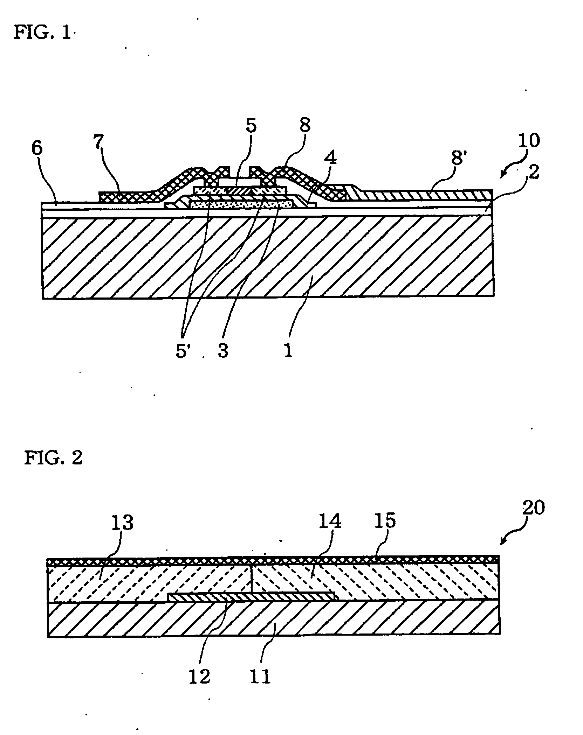

Then, with a transparent glass having a thickness of 2.5 mm as a substrate on the display side, a lower layer film and thin film transistors (TFT) were formed on that substrate by a known method to produce the TFT array substrate 10 as shown in FIG. 1.

For convenience's sake of drawing figures, FIG. 1 shows a conceptual diagram in section of the TFT array substrate, depicting therein only one TFT. In FIG. 1, reference numeral 1 designates a glass substrate having a thickness of 2.5 mm, 2 designates a lower layer film formed on the substrate and having a film thickness of 400 nm, 3 designates a gate electrode, 4 designates a gate insulator, 5 designates a semiconductor film of amorphous silicon (a poly-silicon film may alternatively used), 5' designates a n+layer in which n-type impurities are diffused, 6 designates a passivation film, 7 designates a source wiring, 8 designates a drain wiring, 8' designates a pixel electrode connected with the drain wiring.

On the other hand, with a transparent glass having a thickness of 0.7 mm as a backside substrate opposed to the substrate 1, a light shielding pattern 12 having two layers of chromium oxide and metallic chromium was formed on the glass sheet 11 by a known method. Then, a color filter comprising a red color filter segment 13, a green color filter segment 14 and a blue color filter segment was formed on the light shielding pattern. Further, a transparent counter electrode 15 made of ITO (indium tin oxide) were formed on the color filter. The color filter substrate 20 shown in FIG. 2 was produced in this way.

Thereafter, two liquid crystal alignment layers 22 were formed on the TFT array substrate 10 and the color filter substrate 20, respectively.

Subsequently, with the liquid crystal alignment layers 22, 22 directed inward, the both substrates were laid over them, respectively, and were adhesive bonded to them around marginal portions of four parts into which the overall area was divided, keeping the space therebetween with an interval of 5 micron. Thereafter, the substrates were cut into the four parts to produce four empty cells for a liquid crystal display.

Thereafter, TN type liquid crystals 23 (ZLI4792: available from Merck Japan Limited) were injected into the cells in vacuum and were sealed in the cells to produce the liquid crystal cells 30. Then, a polarizer 24 was adhesive bonded to each side of each of the liquid crystal cells and further a backlight was placed on the color filter substrate 20 side, for completion of a transmission type liquid crystal display 31 having a 20-inch diagonal display. An alternative process may be adopted in which the substrates are cut into the four parts after having been packed with the liquid crystals. In this case, a plurality of liquid crystal injection ports must be formed to inject the liquid crystals into the respective areas of the substrates to be divided into the four parts.

In the liquid crystal display, the front surface of the substrate on the display side is exposed to outside, for its functional reason as the display, and thus is susceptible to damage by an external force, as compared with the substrate on the backside. The liquid crystal display 31 is so designed that the substrate on the display side can have a larger thickness than the substrate on the backside. Consequently, the liquid crystal display is resistant to damage against a strong impact applied from the display side. On the other hand, a thin substrate is used for the backside substrate as compared with the substrate on the display side, so superfluous increase in the mass of the display unit and in costs is avoided. In short, this structure can yields the result that a drastic rise of costs can be suppressed while a required impact resistance and safety is can be ensured. Hence, this structure is particularly useful for a large size liquid crystal display such as a 20-inch or more diagonal display.

For reference's sake, when compared with the liquid crystal display using the aforesaid substrate of 0.7 mm in thickness (Corning 7059), the display unit of this embodiment increased in weight by 2.3 times and the impact resistance of the display unit of this embodiment was 3.6 (3.6 times) where the impact resistance of the aforesaid liquid crystal display was taken as 1. The evaluation was made of the impact resistance in accordance with the test method specified in JIS (Japanese Industrial Standards) R3205 and 3206.

It is to be noted that the combination of the glass substrate of 2.5 mm in thickness (on the display side) and the glass substrate of 0.7 mm in thickness (on the backside) in the above-mentioned embodiment is given as an example of the substrate having a size capable to simultaneously produce four substrates used for the 20-inch diagonal liquid crystal display. The more the glass substrate on the display side increases in thickness, the more the impact resistance increases. However, since the mass of the device increases with an increase in the thickness of the glass substrate on the display side, the glass substrate on the display side should be limited to a necessary and sufficient thickness for the impact resistance.

Our experiments, which were conducted by using the display units with ranges from a 20-inch or more diagonal display to a 45-inch or less diagonal display using the borosilicate glass substrates, showned that with the display units using the glass substrates of 2 mm or more in thickness, when a volleyball for a regular game use was hit against the glass substrate on the display side at the speed of 15 m/s, no fracture or crack was found in the glass substrate on the display side. On the other hand, when consideration is given to a usual using condition of the liquid crystal display and the demerits involved in increase in mass, the use of the substrates of more than 5 mm in thickness was found to be often worthless. These facts show that in the display units with ranges from the 20-inch or more diagonal display to the 45-inch or less diagonal display, the glass substrate on the display side should preferably have a thickness in the range of 2 mm or more to 5 mm or less.

With a borosilicate glass substrate having a thickness in the range of 2 mm or more to 5 mm or less, even when a silicon nitride film or a silica film having a thickness in the range of 100 nanometer or more to 10 micron or less was formed as a lower layer film on the glass substrate and thereafter the TFT array was formed onto the glass substrate through the formed film, the glass substrate was substantially small in deflection or deformation resulting from the heat history in the manufacturing process of the TFT array. With the glass substrate of small in deflection or deformation, alignment precision and dimensional precision of a photo mask used for the production of the TFT array can be improved so that an aperture ratio can be designed to increase. As a result of this, the liquid crystal display having a maximum aperture ratio of 86% was realized. In other words, the liquid crystal display of high in brightness and excellent in high color display property, when compared with the conventional liquid crystal display, was produced without any drastic rise of costs.

### EXAMPLE 2

In Example 2, a transmission type liquid crystal display having a 30-inch diagonal display was produced in the same manner as in Example 1, except that the substrate on the display side was used as the color filter substrate and was 3.2 mm in thickness; that the substrate of 0.7 mm in thickness was used as the backside substrate on which the TFT array was formed; and that two substrates used for a liquid crystal display having a 30-inch diagonal display were simultaneously produced from one glass sheet.

The impact resistance tests were conducted on this display unit in the same manner as in Example 1. It was found from the test results that the display unit had sufficient impact resistance. In this embodiment, the color filter was formed on the substrate of a larger thickness. With increasing thickness, the rigidity of the substrate increases and the distortion resulting from its own weight decreases, thus producing improved alignment precision and dimensional precision for the light shielding pattern. Consequently, an increased aperture ratio of the color filter substrate is yielded and, as a result of this, the liquid crystal display of high in brightness and excellent in high color display property can be produced. In addition, deflection and deformation of the substrate that may occur when a metallic chromium film or a chromium oxide film is formed as a light shielding pattern on the substrate decreases to the extent corresponding to the increased strength of the substrate, thus providing improved display stability.

### EXAMPLE 3

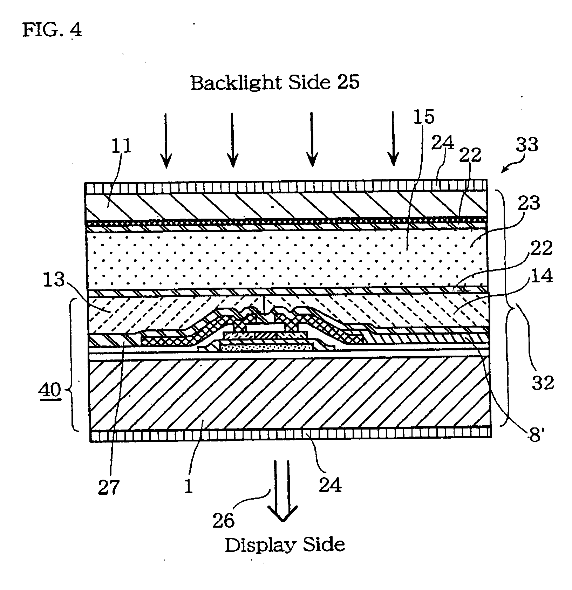

In Example 3, A conceptual diagram in section of this display unit is shown in FIG. 4. While the construction in which a color filter on TFT array substrate 40 is placed on the display side is shown in FIG. 4, an alternative construction in which the color filter on TFT array substrate is placed on the backside may be adopted. In the alternative construction, however, the substrate 11 that will then be the substrate on the display side is required to have a larger thickness than the substrate 1.

The color filter on TFT array substrate was produced in the manner that a flattened film 27 made of silicon dioxide, for example, was formed on the TFT array substrate that was produced in the substantially same manner as in Example 1 (the glass substrate of Corning 7059 of 2.5 mm in film thickness was used) and then a red color filer segment 13, a green color filter segment 14 and a blue color filter segment, not shown, were formed on the flattened film. On the other hand, the substrate on the backside was produced in the manner that transparent counter electrodes were formed on the glass substrate having the thickness of 0.75 mm (Corning 7059). Subsequently, the substrate on the display side and the substrate on the backside were placed over each other to produce the liquid crystal cell 32. Further, the liquid crystal cell thus produced underwent the same process as in Example 1, for completion of the transmission type liquid crystal display 33. The liquid crystal display 33 thus completed was found to have the same impact resistance as that of Example 1. By the same token as the one mentioned in Example 1, the display image quality was improved, as compared with the conventional display unit using the glass substrates of 0.75 mm in thickness for both substrates.

### EXAMPLE 4

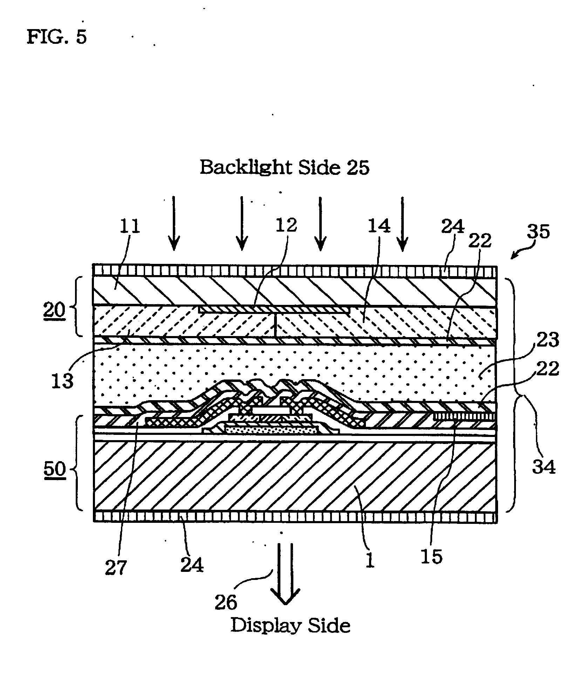

The TFT and the pixel electrodes and counter electrodes 15 connected to the TFT were formed on the glass substrate 1 of 2.5 mm in thickness (Corning 7059) in a known manner. This substrate was used as the substrate on the display side 50. On the other hand, the light shielding film 12 was formed on the glass substrate of 0.7 mm in thickness (Corning 7059) and, further, a group of hues (13, 14, etc.) was formed on the light shielding film. This substrate was used as the backside substrate (opposing substrate). Then, liquid crystal alignment layers 22 were formed on both substrates, respectively, by a conventional procedure. Then, the both substrates were combined, with the alignment layers confronting each other, to produce an in-plane switching type (IPS) liquid crystal display 35 shown in FIG. 5. In FIG. 5, reference numeral 34 designates a cell part of the in-plane switching type liquid crystal.

The liquid crystal display 35, which may be produced by use of the prior art, except that the substrate on the display side 1 is made larger in thickness than the backside substrate 11, was improved in the impact resistance to a great extent and also improved in the luminosity, as compared with the conventional display unit.

### EXAMPLE 5

Examples 1-4 adopted the construction that the borosilicate glass sheets different in thickness from each other were used and the substrate having a larger thickness is placed on the display side, whereas Example 5 adopted the construction that two different kinds of glass sheets different in the strength per unit volume from each other were used and the substrate having a higher strength is placed on the display side. To be more specific, a borosilicate glass sheet of 0.75 mm in thickness (Corning 7059) and a quartz glass sheet of 0.75 mm in thickness (Corning 7940) were used. The TFT array was formed on the quartz glass having a high strength, and the color filter was formed on the borosilicate glass sheet having a lower strength than the former glass sheet. With other matters made equal with those in Example 1, the liquid crystal display was produced.

This examination was made of this liquid crystal display on its impact resistance and its visible clarity, as is the case with Example 1. The examination showed that sufficient impact resistance and visible clarity were yielded. It was found from this that the safety and performance as the display unit could be fully enhanced without any need for the use of a costly quartz glass to the backside substrate as well. Instead of the quartz glass used in this Example, a glass sheet or a resin sheet of high strength, such as a reinforced glass, may be used.

### EXAMPLE 6

First, there were prepared three transparent borosilicate glass sheets (Size: 550 mm × 650 mm/Corning 7059 available from Corning Corp.) each having a size capable to simultaneously produce four substrates used for 20-inch diagonal liquid crystal displays having thickness of 0.7 mm. One of them was divided into four parts, which were prepared as laminating glass sheets.

On the other hand, two of the glass sheets, or two glass sheets having the same thickness, were used to produce the liquid crystal cell in the same manner as in Example 1. The laminating glass sheets previously prepared were laminated on only a TFT forming side of the substrate (a TFT array side of the substrate) of the both outside surfaces of this liquid crystal cell by means of transparent adhesive. Thus, the liquid crystal cell having the TFT array substrate larger in thickness than the color filter substrate was formed. Then, a polarizer was placed on each side of the cell. Further, a backlight was placed on the color filter substrate side to take the TFT array substrate side as the display side to thereby produce the transmission type liquid crystal display having the feature that the substrate on the display side is larger in thickness.

Instead of the aforesaid three glass sheets of identical in thickness and material to each other, three glass sheets of different in thickness and/or material from each other may alternatively be used. For instance, the borosilicate glass of 0.7 mm in thickness may be used for the backside substrate and the substrate on the display side may be in the form of a laminated substrate formed by the quartz glass having the thickness of 0.4 mm and the borosilicate glass having the thickness of 0.7 mm being adhesive bonded. In the above, the substrate on the display side used includes but not limited to the TFT array substrate. Any laminated substrate formed by two or more substrates being laminated so that the substrate on the display side can be made larger in thickness than the backside substrate may be used as the substrate on the display side.

### EXAMPLE 7

In Example 6 the separately prepared glass sheet was laminated on the substrate (the substrate on the display side) on which the TFT was formed, whereas in Example 7 a polarizer was laminated on the substrate on the display side, first, and then the separately prepared glass sheet was laminated on the polarizer. With other matters made equal with those in Example 6, the transmission type liquid crystal display having the substrate on the display side having a larger thickness than the backside substrate was produced.

This manufacturing process, in which after the liquid crystal cell was assembled, the substrates are adhesive bonded to each other through the polarizer to produce a composite substrate, can produce the advantages that the impact resistance of the display screen can be increased in a simple and easy manner and that since the polarizer is protected by the substrate situated on the outside of it, the reliability and safety as the display unit can be significantly improved. In the illustrated construction, the substrate on the display side used includes but not limited to the TFT array substrate, as is the case with Example 6.

### EXAMPLE 8

In Example 8, the transmission type liquid crystal display was produced in the same manner as in Example 7, except that a transparent resin sheet was adhesive bonded to the display side of the liquid crystal cell, first, and then the separately prepared glass sheet was laminated on it. When the examination was made of the impact resistance of the display side of this display unit, it was confirmed that the impact resistance was further improved, as compared with the case where a plurality of glass sheets are simply laid over the display side. This seems to be because two different materials having different properties, i.e., the glass sheet having a higher hardness than the resin sheet and the soft and flexible resin sheet, interacted conveniently to soften the impact.

Various kinds of materials may be used for the resin sheets, including, for example, polycarbonate, polyethylene terephthalate, polyethylene and nylon. It is to be noted that a substrate formed by a plurality of substrates being adhesive bonded with an additional substrate of different material (e.g. a polarizer or a resin sheet) sandwiched therebetween is referred to as the "composite substrate" in this specification.

### OTHER RESPECTS

(1) In Examples 1-8, a resin sheet may be used as a basic component of the liquid crystal cell, instead of the glass sheet. In this case, Example 8 will be modified by, for example, further laminating an additional resin sheet onto the resin sheet on the display side through the glass sheet.
(2) The present invention is characterized by the specific thickness and strength of the substrate on the display side. Accordingly, any known methods or processes may selectively be used for the remaining matters, such as the TFT producing process, the color filter producing process and the liquid crystal injection method. Also, the present invention may be applied not only to transmission type liquid crystal display but also to reflective liquid crystal displays. In addition, the forming of the TFT on the resin sheet may be provided by a silicon polycrystallization technique in accordance with a known low-temperature process, for example.

## Claims

1. A liquid crystal display comprising a liquid crystal cell in which a first substrate forming thereon at least thin film transistors and pixel electrodes connected to said thin film transistors and a second substrate forming thereon at least color filter layers and counter electrodes are opposed to each other with a predetermined gap, with electrode surfaces thereof faced inward, and liquid crystals are sealed in said gap, wherein either of both outside surfaces of said liquid crystal cell is on a display side and the substrate on the display side is larger in thickness than the substrate opposed to said substrate on the display side.

2. A liquid crystal display according to Claim 1, wherein said substrate on the display side comprises a composite substrate formed by two transparent substrates being laminated with a transparent resin sheet sandwiched therebetween.

3. A liquid crystal display comprising a liquid crystal cell in which a first substrate forming thereon at least thin film transistors, pixel electrodes connected to said thin film transistors, and color filter layers laminated on said pixel electrodes and a second substrate forming thereon at least counter electrodes are opposed to each other with a predetermined gap, with electrode surfaces thereof faced inward, and liquid crystals are sealed in said gap, wherein either of both outside surfaces of said liquid crystal cell is on a display side and the substrate on the display side is larger in thickness than the substrate opposed to said substrate on the display side.

4. A liquid crystal display according to Claim 3, wherein said substrate on the display side comprises a composite substrate formed by two transparent glass substrates being laminated with a transparent resin sheet sandwiched therebetween or a composite substrate formed by two transparent resin sheets being laminated with a transparent glass sheet sandwiched therebetween.

5. A liquid crystal display of an in-plane switching type comprising an in-plane switching type liquid crystal cell in which a first substrate forming thereon at least thin film transistors, pixel electrodes connected to said thin film transistors and counter electrodes spaced from said pixel electrodes and a second substrate axe opposed to each other with a predetermined gap, with electrode surfaces thereof faced inward, and liquid crystals are sealed in said gap, wherein either of both outside surfaces of said liquid crystal cell is on a display side and the substrate on the display side is larger in thickness than the substrate opposed to said substrate on the display side.

6. A liquid crystal display according to Claim 5, wherein said substrate on the display side comprises a composite substrate formed by two transparent glass substrates being laminated with a transparent resin sheet sandwiched therebetween.

7. A liquid crystal display according to any preceding Claim, wherein said substrate on the display side comprises a laminated substrate formed by a plurality of transparent substrates being adhesive bonded.

8. A liquid crystal display according to any preceding Claim, wherein said substrate on the display side comprises a composite substrate formed by two transparent substrates being laminated with a polarizer sandwiched therebetween.

9. A liquid crystal display according to any of Claims 1 to 6, wherein said substrate on the display side comprises a borosilicate glass sheet having a thickness in the range of 2 mm or more to 5 mm or less.

10. A liquid crystal display according to Claim 9, wherein said substrate on the display side is said first substrate forming thereon said thin film transistors, and said thin film transistors are formed on said first substrate through a lower layer film having a film thickness in the range of 100 nanometer or more to 10 micron or less.

11. A liquid crystal display according to Claim 10, wherein an image display surface on said display side has a rectangular shape and has a diagonal size of 20 inch or more.

12. A liquid crystal display of an in-plane switching type comprising an in-plane switching type liquid crystal cell in which a first substrate forming thereon at least thin film transistors, pixel electrodes connected to said thin film transistors and counter electrodes spaced from said pixel electrodes and a second substrate are opposed to each other with a predetermined gap, with electrode surfaces thereof faced inward, and liquid crystals are sealed in said gap, wherein either of both outside surfaces of said liquid crystal cell is on a display side and the substrate on the display side is larger in strength per unit volume than the substrate opposed to said substrate on the display side.

13. A liquid crystal display according to Claim 5 or Claim 12, wherein color filter layers are further formed on said pixel electrodes and counter electrodes of said first substrate

14. A liquid crystal display according to Claim 12 or Claim 13, wherein color filter layers are formed on said second substrate, and color filter surfaces thereof are opposed to electrode surfaces of said first substrate.

15. A liquid crystal display comprising a liquid crystal cell in which a first substrate forming thereon at least thin film transistors and pixel electrodes connected to said thin film transistors and a second substrate forming thereon at least color filter layers and counter electrodes are opposed to each other with a predetermined gap, with electrode surfaces thereof faced inward, and liquid crystals are sealed in said gap, wherein either of both outside surfaces of said liquid crystal cell is on a display side and the substrate on the display side is larger in strength per unit volume than the substrate opposed to said substrate on the display side.

16. A liquid crystal display comprising a liquid crystal cell in which a first substrate forming thereon at least thin film transistors, pixel electrodes connected to said thin film transistors, and color filter layers laminated on said pixel electrodes and a second substrate forming thereon at least counter electrodes are opposed to each other with a predetermined gap, with electrode surfaces thereof faced inward, and liquid crystals are sealed in said gap, wherein either of both outside surfaces of said liquid crystal cell is on a display side and the substrate on the display side is larger in strength per unit volume than the substrate opposed to said substrate on the display side.

17. A liquid crystal display according to any preceding Claim, wherein said substrate on the display side is said first substrate forming thereon said thin film transistors.

18. A producing process of a liquid crystal display comprising:
a TFT array substrate producing step that after two substrates having different thickness are prepared, at least thin film transistors and pixel electrodes connected to said thin film transistors are formed on the larger thickness one of said two substrates;
an opposing substrate forming step that at least transparent counter electrodes are formed on the smaller thickness one of said two substrate;
a step that said TFT array substrate and said opposing substrate are opposed to each other with a predetermined gap, with electrode surfaces thereof faced inward;
a liquid crystal cell assembling step that liquid crystals are sealed in said gap;
a step that a polarizer is placed on each of two outside surfaces of said liquid crystal cell; and
a step that a backlight is placed on said opposing substrate of said liquid crystal cell on the side thereof on which said polarizer is placed.

19. A producing process of a liquid crystal display comprising:
a TFT array substrate producing step that after three substrates of first, second and third substrates are prepared, at least thin film transistors and pixel electrodes connected to said thin film transistors are formed on said first substrate;
an opposing substrate forming step that at least transparent counter electrodes are formed on said second substrate;
a step that said TFT array substrate and said opposing substrate are opposed to each other with a predetermined gap, with electrode surfaces thereof faced inward;
a liquid crystal cell assembling step that liquid crystals are sealed in said gap;
a laminating step that said third substrate is laminated on an outside surface of said TFT array substrate of said liquid crystal cell so that the entire thickness thereof can be made larger than that of said second substrate;
a step that a polarizer is placed on each of two outside surfaces of said liquid crystal cell after said laminating step; and
a step that a backlight is placed on said opposing substrate on the side thereof on which said polarizer is placed.

20. A producing process according to Claim 19, wherein said first, second and third substrates are made of glass and are equal in thickness to each other.

21. A producing process according to Claim 19, wherein said first substrate and said third substrate are different in material property from each other.

22. A producing process of a liquid crystal display comprising:
a TFT array substrate producing step that after three substrates of first, second and third substrates are prepared, at least thin film transistors and pixel electrodes connected to said thin film transistors are formed on said first substrate;
an opposing substrate forming step that at least transparent counter electrodes are formed on said second substrate;
a step that said TFT array substrate and said opposing substrate are opposed to each other with a predetermined gap, with electrode surfaces thereof faced inward;
a liquid crystal cell assembling step that liquid crystals are sealed in said gap;
a laminating step that a polarizer is laminated on an outside surface of said TFT array substrate of said liquid crystal cell and further said third substrate Is laminated on said polarizer so that the entire thickness thereof can be made larger than that of said second substrate;
a step that a polarizer is placed on an outside surface of said opposing substrate; and
a step that a backlight is placed on said opposing substrate on the side thereof on which said polarizer is placed.

23. A producing process according to Claim 21, wherein at least said first and third substrates are made of glass.

24. A producing process of a liquid crystal display comprising:
a TFT array substrate producing step that after four substrates of a first substrate, a second substrate, a third substrate different in material property from said first substrate and a fourth substrate identical in meterial property to said first substrate are prepared, at least thin film transistors and pixel electrodes connected to said thin film transistors are formed on said first substrate;
an opposing substrate forming step that at least transparent counter electrodes are formed on said second substrate;
a step that said TFT array substrate and said opposing substrate are opposed to each other with a predetermined gap, with electrode surfaces thereof faced inward;
a liquid crystal cell assembling step that liquid crystals are sealed in said gap;
a laminating step that said third substrate is laminated on an outside surface of said TFT array substrate of said liquid crystal cell and further said fourth substrate is laminated on said third substrate so that the entire thickness thereof can be made larger than that of said second substrate;
a step that a polarizer is placed on an outside surface of said opposing substrate; and
a step that a backlight is placed on said opposing substrate on the side thereof on which said polarizer is placed.

25. A producing process according to Claim 24, wherein said first substrate is made of glass and said third substrate is made of resin.
